# EUROPÄISCHE PATENTSCHRIFT

(11) **EP 3 355 073 B1**
(45) Veröffentlichungstag und Bekanntmachung des Hinweises auf die Patenterteilung: **18.05.2022**
(21) Anmeldenummer: 17153978.6
(22) Anmeldetag: 31.01.2017
(51) Int. Cl.: G01R 31/08, H02J 3/00

(54) **GENERIERUNG VON MUSTERN FÜR DIE IDENTIFIKATION VON FEHLERFÄLLEN IN STROMNETZEN**
GENERATION OF PATTERNS FOR THE IDENTIFICATION OF ERRORS IN ELECTRIC POWER GRIDS
PRODUCTION DE MODÈLES POUR L'IDENTIFICATION DE CAS D'ERREUR DANS DES RÉSEAUX ÉLECTRIQUES

(43) Veröffentlichungstag der Anmeldung: 01.08.2018
(73) Patentinhaber: Siemens Aktiengesellschaft, 80333 München (DE)
(72) Erfinder: Münz, Ulrich, Plainsboro, 08536 (US); Beyer, Dagmar, 80339 München (DE); Heyde, Chris Oliver, 91058 Erlangen (DE)

(56) Entgegenhaltungen:
- EP-A1- 1 381 132
- EP-A1- 2 978 096
- DE-A1-102004 058 619

## Beschreibung

Die Erfindung betrifft ein Verfahren und ein System zur Generierung von Mustern für die Identifikation von Fehlerfällen in Stromnetzen, ein Verfahren und ein System zur Identifikation von Fehlerfällen in Stromnetzen und ein Computerprogrammprodukt.

Während des Betriebs eines Stromnetzes muß gewährleistet sein, daß bei einer Störung einzelner Komponenten oder Betriebsmittel die Stabilität des Stromnetzes insgesamt erhalten bleibt. Dazu ist eine Überwachung des Netzes erforderlich. Dies wird meist anhand von Meldungen an für die Netzsteuerung vorgesehene Leitwarten realisiert. Die Meldungen stammen von Schutzgeräten oder anderen lokalen Meßgeräten. Die Auswertung dieser Meldungen, die unabhängig voneinander in der Leitwarte einlaufen, erfolgt in vielen Fällen manuell. Dabei beinhalten die Meldungen die Resultate von Fehlern im Netz aber evtl. nicht die physikalischen Größen selbst. Eine Meldung wäre zum Beispiel die Information, daß wegen einer bestimmten Einstellung ein Schutzgerät ausgelöst hat. Ist aus derartigen Meldungen keine eindeutige Klärung möglich, dann können aus den Feldgeräten sogenannte Fault Records, d.h. Fehlerprotokolle, ausgelesen werden, die die physikalischen Meßdaten in hoher Auflösung enthalten. Dieser Prozeß wird derzeit auch noch vielfach manuell durchgeführt.

Neue Möglichkeiten zur Überwachung ergeben sich durch sogenannte Phasor Measurement Units (PMUs), mit welchen immer mehr Stromnetze ausgestattet werden. Diese PMUs werden in der deutschsprachigen Literatur auch als Zeigermeßgeräte bezeichnet und die von ihnen gemessenen Daten als Zeigerdaten oder Zeigermeßdaten. Mit dem PMUs können hochaufgelöst und zeitsynchron Ströme und Spannungen an verschiedenen Punkten in Stromnetzen gemessen werden. PMUs greifen häufig auf Satellitentechnik zurück und erlauben eine zeitsynchrone Messung und Überwachung in Echtzeit. Die so erhaltenen Daten werden heute beispielsweise verwendet, um Leistungspendelungen und andere kritische Ereignisse im Stromnetz zu erkennen.

Allerdings ist es immer noch sehr schwierig, die ursächlichen Fehler (Englisch: contingencies) für diese kritischen Ereignisse aus den PMU-Meßwerten zu identifizieren. Die Rekonstruktion der ursächlichen Fehler kann mit Hilfe von Modellierung von Netzzuständen versucht werden. In der EP 2978096 A1 wird ein modellbasiertes Vorgehen zur Auffindung bzw. Identifikation von Fehlerfällen im Netz vorgeschlagen. Dabei werden durch Modellierung von mit Fehlern behafteten Netzzuständen Muster für die Identifikation von Fehlerfällen (im Folgenden werden die Muster für die Identifikation von Fehlerfällen auch als Fehlermuster bezeichnet) generiert und diesen Fehlermuster Maßnahmen zur Sicherung der Netzstabilität zugeordnet. Diese Informationen werden in einem Datenspeicher abgelegt. Bei Auftreten eines Fehlermusters im Netz kann dann das Muster mit den im Datenspeicher vorhandenen Fehlermustern verglichen werden. Durch Identifikation des entsprechenden Fehlermusters in dem Datenspeicher werden dann der zugehörige Fehler und die erforderliche Maßnahme identifiziert. EP1381132 offenbart ein Verfahren zur Ermittlung von Parametern eines Stromnetzes auf Basis eines Modells mit dem Ziel, die Frequenzinstabilitäten des Netzes zu korrigieren.

Es besteht ein Bedarf, derartige modellbasierte Netzfehlererkennung auf Basis von Fehlermustern weiter zu verbessern.

Die Erfindung hat die Verbesserung von Netzfehlererkennung auf Basis von Fehlermustern zur Aufgabe.

Diese Aufgabe wird jeweils durch ein Verfahren zur Generierung von Mustern für die Identifikation von Fehlerfällen in Stromnetzen nach Anspruch 1, ein Verfahren zur Identifikation von Fehlerfällen in Stromnetzen nach Anspruch 9, ein System zur Generierung von Mustern für die Identifikation von Fehlerfällen in Stromnetzen nach Anspruch 11, ein System zur Identifikation von Fehlerfällen in Stromnetzen nach Anspruch 12 und ein Computerprogrammprodukt nach Anspruch 13 gelöst. Die Erfindung basiert auf der Erkenntnis, daß Fehlermuster in der Regel nicht nur charakterisierend für den zugehörigen Fehler sind, sondern auch von dem nominellen (d.h. fehlerfreien) Zustand des Netzes abhängen, d.h. relativ spezifisch sind.

Daher wird gem. einer Ausgestaltung des Erfindungsgegenstands ein Verfahren zur Generierung von Mustern für die Identifikation von Fehlerfällen in Stromnetzen vorgeschlagen, bei dem der Einfluß von nominellen Netzzuständen auf die generierten Fehlermuster weitgehend eliminiert wird. Der Begriff "Stromnetz" ist dabei weit zu interpretieren. Er soll jede Verbindung von Elementen umfassen, mit der zwischen den Elementen Strom zwecks Energieversorgung von Elementen ausgetauscht wird. Beispiele sind nicht nur Stromübertragungs- und Stromverteilungsnetzte im Hoch-, Mittel- und Niederspannungsbereich. Die Erfindung ist generell auf alle komplexen mit Strom betriebenen technischen Systeme anwendbar, bei denen eine Modellierung der Stromversorgung von Systembestandteilen vorgesehen wird.

Gemäß dieser Ausgestaltung werden die im Folgenden beschriebenen Schritte für verschiedene Zeitpunkte durchgeführt und damit ein Muster für einen zeitlichen Verlauf nach einem möglichen Fehler erzeugt. Diese Durchführung kann aber muß nicht zu diesen verschiedenen Zeitpunkten erfolgen, d.h. das Verfahren umfaßt sowohl eine Echtzeit- als auch eine Offlinegenerierung von Mustern. Als ein erster Schritt werden in einem Stromnetz einen Zustand des Stromnetzes charakterisierende Werte für meßbare stromnetzspezifische Größen verwendet. Dabei bezeichnet "meßbar" den Datentypus. Die Werte selber können, aber müssen nicht durch Messung bestimmt sein. Gem. einer Ausgestaltung handelt es sich um durch Modellierung bzw. Simulation erhaltene Werte. Die Größen selber können insbesondere auch Größen sein, deren Werte als Zeigerdaten, d.h. durch Zeigermeßgeräte meßbar sind. Unter einem Stromnetz ist dabei hier und im Folgenden jedes Netz zu verstehen, das für die Übertragung und Verteilung von elektrischer Energie vorgesehen bzw. geeignet ist, insbesondere Hochspannungs-, Mittelspannungs- und Niederspannungsverteilungsnetze.

In einem weiteren Schritt werden Werte für die stromnetzspezifischen Daten mittels eines Modells für das Stromnetz bestimmt. Diese Bestimmung kann beispielsweise mittels eines Beobachters im Sinne der Regeltechnik erfolgen, d.h. mittels eines Systems, das aus den Werten bekannter Eingangsdaten und Ausgangsdaten eines beobachteten Referenzsystems Werte von nicht meßbaren Größen bestimmt. Dabei basiert die Bestimmung mittels Modell auf bekannten netzspezifischen Eingangsgrößen und nicht bekannten netzspezifischen Größen bzw. Zuständen. Die bekannten netzspezifischen Eingangsgrößen können z.B. die oben angesprochenen meßbaren stromnetzspezifischen Größen umfassen. Die Werte der nicht bekannten netzspezifischen Größen sind nach Maßgabe eines fehlerfreien funktionierenden Stromnetzes (d.h. nomineller Zustand bzw. nominelles Verhalten des Netzes) festgelegt. Das Modell kann durch geeignete Rückkopplung der bekannten netzspezifischen Größen geregelt sein, so daß der Zustand des Modells möglichst genau dem netzzustand entspricht (z.B. wie oben beschrieben einen Beobachter im Sinne der Reglungstechnik darstellen), wobei aber die Randbedingung der Annahme des fehlerfreien bzw. nominellen Funktionierens des Netzes gilt.

Die Generierung eines Musters für die Identifikation von Fehlerfällen erfolgt dann durch Bildung der Differenz zwischen den den Zustand des Stromnetzes charakterisierenden Werten und den mittels Modell bestimmten Werten für die verschiedenen Zeitpunkte.

Die derart generierten Muster sind weitgehend vom nominellen Zustand des Netzes unabhängig oder zumindest unabhängiger. D.h. für einen bestimmten Fehler erhält man bei unterschiedlichen nominellen Netzzuständen identische oder zumindest ähnliche Muster. Dies ist von Vorteil bei Analysen, weil eine bessere Übertragbarkeit von Modellierungsergebnissen und eine Reduktion von Komplexität (wegen der geringeren Anzahl von Fehlermustertypen) erreicht werden.

Gemäß einer Ausgestaltung des Verfahrens werden Werte für die meßbaren stromnetzspezifischen Größen mittels Simulation bestimmt. In diesem Fall ist ein Systems zur Simulation von Zuständen des Stromnetzes für verschiedene, Fehlerfällen entsprechenden Zustände des Stromnetzes gegeben. Mit diesem System werden die den jeweiligen Zustand des Stromnetzes charakterisierenden Werte für die meßbaren stromnetzspezifische Größen bestimmt. Mittels dieser Werte werden dann die Muster für die Identifikation von den jeweiligen Fehlerfällen generiert. Man erhält somit Muster, die simulierten Fehlerfällen entsprechen, d.h. man hat eine Zuordnung zwischen Mustern und Fehlerfällen. Diese Zuordnung von Mustern für die Identifikation von Fehlerfällen (d.h. Fehlermuster) zu Fehlerfällen kann in einer Datenbank abgespeichert werden. Dabei kann die Zuordnung auch indirekter Natur sein. Z.B. kann eine Zuordnung von Mustern für die Identifikation von Fehlerfällen zu Maßnahmen gegen die zugehörigen Fehlerfälle erfolgen und in einer Datenbasis abgespeichert werden, d.h. hier ist der jeweilige Fehlerfall durch die Gegenmaßnahme bzw. Gegenmaßnahmen indiziert.

Bei einer anderen Ausgestaltung des Verfahrens sind die einen Zustand des Stromnetzes charakterisierenden Werte für meßbare stromnetzspezifische Größen durch die entsprechenden Meßwerte gegeben. Es werden dann für eine Mehrzahl von verschiedenen Modellen Werte für die stromnetzspezifischen Größen mittels des Modells bestimmt. Dabei basiert die Bestimmung mittels Modell auf bekannten netzspezifischen Eingangsgrößen und nicht bekannten netzspezifischen Größen bzw. Zuständen. Die nicht bekannten netzspezifischen Größen sind nach Maßgabe eines Fehlerfalls im Stromnetz festgelegt. Ein Muster für die Identifikation von Fehlerfällen wird durch Bildung der Differenz zwischen den den Zustand des Stromnetzes charakterisierenden Werten und den mittels Modell bestimmten Werten für die verschiedenen Zeitpunkte generiert. Es kann dann aus den für die Mehrzahl der Modelle generierten Mustern ein Muster nach Maßgabe des auf die Mehrzahl bezogenen Minimums eines Maßes für die absolute Größe von Werten des Musters (z.B. ggf. gewichtete Addition der Beträge von Werten des Musters über einen spezifizierten Bereich) identifiziert und von dem identifizierten Muster auf den zugehörigen Fehlerfall geschlossen werden.

Die Erfindung umfaßt auch ein Verfahren zur Identifikation von Fehlerfällen in Stromnetzen. Hierbei werden für verschiedene Zeitpunkte in einem Stromnetz Meßwerte für stromnetzspezifische Größen verwendet und Werte für die stromnetzspezifischen Größen mittels eines Modells für das Stromnetz bestimmt. Bei dem Modell handelt es sich vorzugsweise um dasselbe Modell bzw. denselben Beobachter, das bzw. der für das erfindungsgemäße Verfahren zur Generierung von Mustern für die Identifikation von Fehlerfällen in Stromnetzen zum Einsatz kommt. Die Bestimmung mittels Modell basiert auf bekannten netzspezifischen Eingangsgrößen und nicht bekannten netzspezifischen Größen bzw. Zuständen, wobei die Werte der nicht bekannten netzspezifischen Größen nach Maßgabe eines fehlerfreien funktionierenden Stromnetzes festgelegt sind. Ein Muster für die Identifikation von Fehlerfällen wird durch Bildung der Differenz zwischen den Meßwerten und den mittels Modell bestimmten Werten für die verschiedenen Zeitpunkte generiert. Schließlich wird das Muster mit in einer Datenbank gespeicherten, nach einem erfindungsgemäßen Verfahren nach erzeugten und Fehlerfällen zugeordneten (typischerweise 1:1 Zuordnung) Mustern verglichen. Durch den Vergleich erfolgt die Identifizierung des dem Muster zugeordneten Fehlerfalls (evtl. inkl. der für den Fehlerfall zu treffenden Maßnahme).

Die Erfindung umfaßt zudem eine Datenbasis mit nach einem erfindungsgemäßen Verfahren erzeugten und Fehlerfällen zugeordneten Mustern und Systeme sowie ein Computerprogrammprodukt zur Durchführung der erfindungsgemäßen Verfahren. Die Datenbank und die Systeme können auf Basis herkömmlicher Hardware, z.B. Rechen- bzw. Speichermittel, konzipiert werden.

Im Folgenden wird die Erfindung im Rahmen von Ausführungsbeispielen anhand von Figuren näher beschrieben. Es zeigen:
Fig. 1: ein System zur simulationsbasierten Erzeugung von Fehlermustern,
Fig. 2: eine fehlermusterbasierte Fehleridentifikation,
Fig. 3: die Abhängigkeit von Fehlermustern vom nominellen Netzzustand,
Fig. 4: eine Generierung von erfindungsgemäßen Fehlermustern, und
Fig. 5: eine Fehleridentifikation auf Basis von erfindungsgemäßen Fehlermustern.

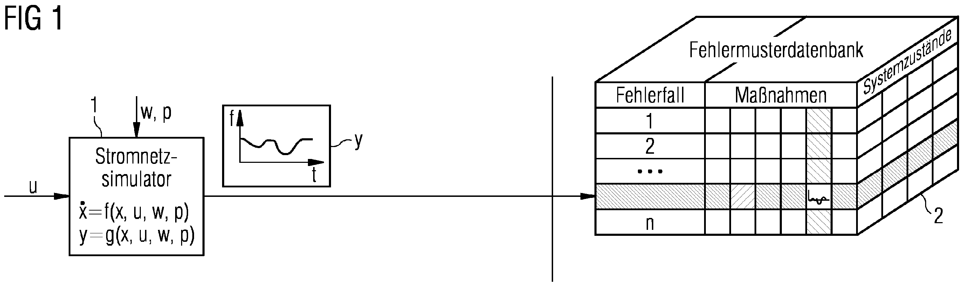

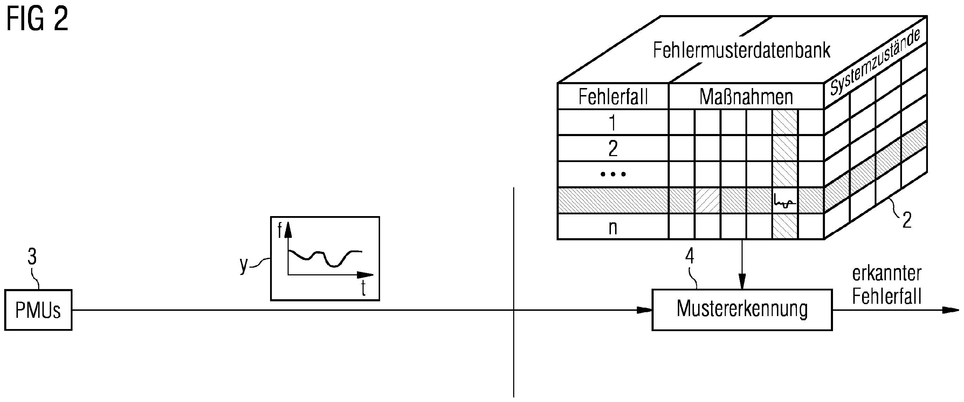

Eine Möglichkeit zur simulationsbasierten Identifikation von Fehlerfällen wird im Folgenden anhand von Fig. 1 und Fig. 2 dargestellt. In Fig. 1 ist ein System 1 zur Simulation von Zuständen eines Stromnetzes (Im Folgenden: Stromnetzsimulator) gezeigt. Folgende Größen spielen bei der Simulation eine Rolle:

| | Bedeutung | Beispiele |
|---|---|---|
| u | bekannter Input | Bezugsleistung für Hochspannungsgleichstrom (HVDC) |
| w,p | unsicherer Input und unsichere Parameter | Stromzufuhr durch Solar- oder Windkraftanlage, Verfügbarkeit von Stromleitung |
| x | Systemzustände | Frequenz von Generator i |
| y | meßbarer Output | PMU Messungen |

Das Vorgehen besteht aus zwei wesentlichen Schritten:
1. Zunächst wird zur Laufzeit des Stromnetzes (z.B. alle 15 Minuten) der Zustand des Netzes bestimmt, und es werden davon ausgehend verschiedene Fehlerfälle mithilfe des Stromnetzsimulators 1 simuliert. In Fig. 1 ist ein simuliertes Fehlermuster y gezeigt. Idealerweise werden dabei auch mögliche Gegenmaßnahmen mit simuliert und dahingehend bewertet, ob diese Gegenmaßnahmen helfen, die Auswirkungen des Fehlers zu reduzieren. Während dieser Simulation werden Fehlermuster y aufgezeichnet, die den PMU-Meßwerten des realen Systems in einem solchen Fehlerfall entsprechen. Diese Fehlermuster werden in einer Fehlermusterdatenbank 2 (pattern data base) abgelegt, die diese Fehlermuster nach dem aktuellen Systemzustand (system state), dem Fehlerfall (contingency) und der Gegenmaßnahme (measures) sortiert.
2. Der zweite wesentliche Schritt wird anhand von Fig. 2 beschrieben. Wenn während des Betriebs ein beginnendes kritisches Verhalten, z.B. eine Leistungspendelung, erkannt wird, werden die gemessenen PMU-Werte bzw. das entsprechende Fehlermuster y mit den vorab für den aktuellen Netzzustand simulierten Fehlermustern verglichen. Für diese Mustererkennung 4 (pattern recognition) können verschiedene datenbasierte Ansätze verwendet werden. Auf diese Weise kann idealerweise die Fehlerursache erkannt und geeignete Gegenmaßnahmen vorgeschlagen werden.

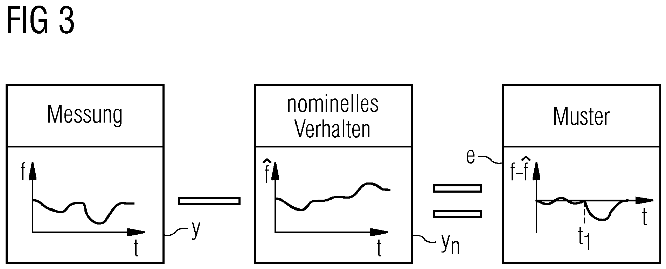

Ein Ausgangspunkt für ein erfindungsgemäßes Vorgehen ist die Erkenntnis, daß die verwendeten bzw. gemessenen Fehlermuster y vom nominellen Netzzustand abhängen. Dieser auf dem nominellen Verhalten des Netzes zurückgehende Anteil wird erfindungsgemäß stark reduziert. Dies ist in Fig. 3 illustriert. Vom gemessenen Fehlermuster y wird ein dem nominellen Zustand entsprechendes Muster yₙ abgezogen, so daß eine Fehlermuster e resultiert, das nicht mehr für die Überlagerung von nominellen Verhalten und Fehlerverhalten charakteristisch ist, sondern nur für das Fehlerverhalten. Wie an dem Muster e gut zu sehen ist, entspricht das tatsächliche Verhalten zunächst dem nominellen. Ab Zeitpunkt t₁ beginnt sich ein Fehlverhalten einzustellen, das sich in einem Ausschlag der Kurve äußert.

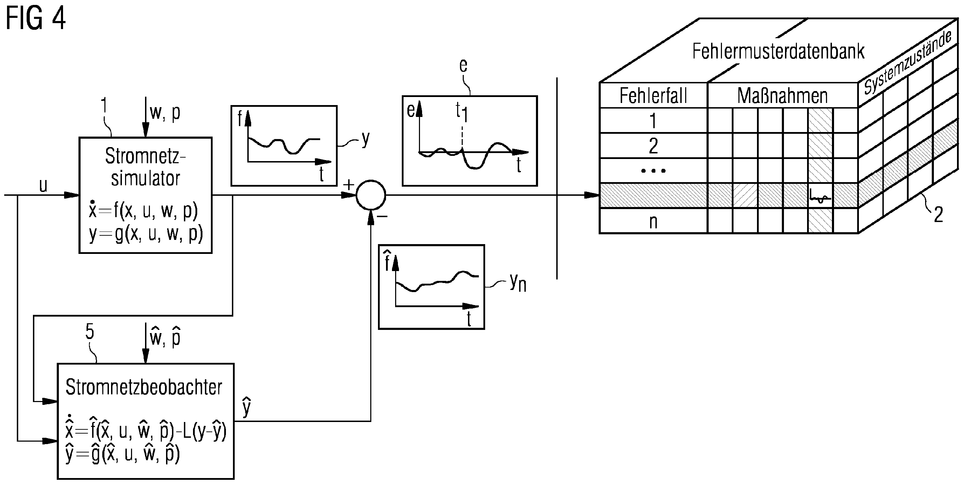

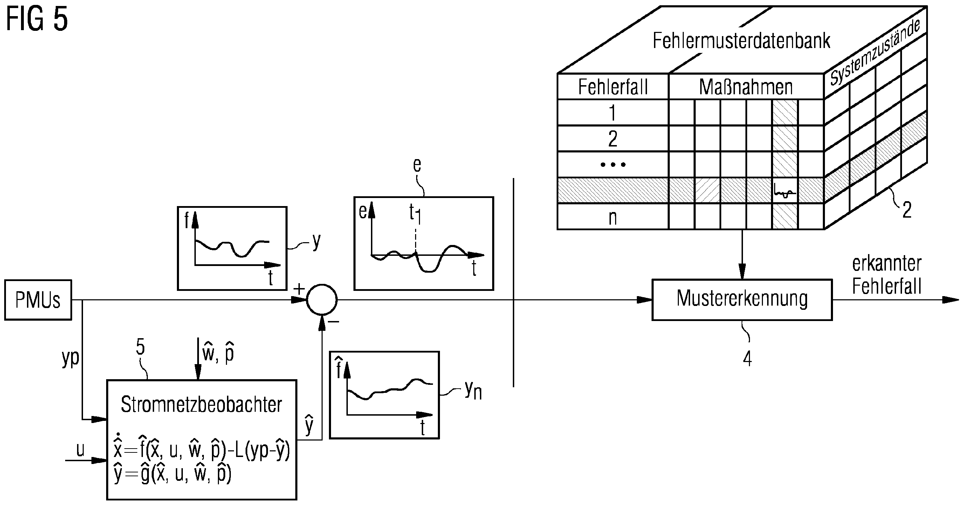

Zur Implementierung eines erfindungsgemäßen Eliminierens des nominellen Netzzustandes wird z.B. das anhand von Fig. 1 und Fig. 2 beschriebene Verfahren durch einen Beobachter 5 ergänzt. Dies wird im Folgenden anhand von Fig. 4 und Fig. 5 illustriert. In Fig. 4 bzw. Fig. 5 spielen folgende Größen eine Rolle:

| | Bedeutung | Beispiele |
|---|---|---|
| u | bekannter Input | Übertragungsleistung für Hochspannungsgleichstrom (HVDC) |
| w,p | unsicherer Input und unsichere Parameter | Stromzufuhr durch Solar- oder Windkraftanlage, Verfügbarkeit von Stromleitung |
| x | Systemzustände | Frequenz von Generator i |
| y | meßbarer Ausgang | PMU Messungen |
| w,p | Schätzungen von w, p | Letzte bekannte Werte für Stromzufuhr durch Solar- oder Windkraftanlage |
| e | Beobachterfehler = beobachterbasiertes Fehlermuster | |
| L | Beobachterverstärkung, reduziert e zu null im fehlerfreien Zustand | |

In einem ersten Schritt werden Fehlermuster generiert und abgespeichert. Der Beobachter 5 besitzt dabei ein Modell des Stromnetzes, daß nicht unbedingt mit dem Modell des Stromnetzsimulators 1(power system simulator) übereinstimmen muß. Beispielsweise kann es sich um ein lineares Modell handeln, das dem am aktuellen Arbeitspunkt linearisierten Stromnetzmodell des Stromnetzsimulators entspricht. Das Beobachtermodell kann z.B. alle 15 Minuten um den aktuellen Arbeitspunkt neu linearisiert werden. Außerdem besitzt der Beobachter den aus der Literatur bekannten Korrekturterm L(y-^y), der den Beobachterfehler x-^x im fehlerfreien Fall immer sehr klein werden läßt (z.B. aus Reglungstechnik bekannter Luenberger-Beobachter). Somit ist im fehlerfreien Betrieb die Abweichung zwischen den simulierten PMU-Meßwerten y und dem Beobachterausgang ^y nahezu null, was auch anhand von dem Muster e in Fig. 4 zu ersehen ist.

Ein Fehlerfall wird im Stromnetzsimulator 1 durch die Änderung einer Eingangsgröße w oder eines Parameters p des Simulationsmodells während der Simulation modelliert. Beispiele hierfür sind in der oben stehenden Tabelle angegeben. Im Beobachter 5 werden diese Eingangsgrößen und Parameter während der Simulation des Fehlers allerdings nicht verändert. Daher stimmen nach dem Fehlerfall die Modelle des Stromnetzsimulators 1 und des Beobachters 5 nicht mehr überein und somit weichen auch die simulierten PMU Werte y und die entsprechende Werte des Beobachters ^y voneinander ab. Das resultierende Fehlersignal e = y - ^y ist vor dem Fehler nahezu null und weicht nach dem Fehler deutlich von null ab, vgl. Fig. 4. Im Gegensatz zum anhand von Fig. 1 und Fig. 2 beschriebenen Verfahren wird das Fehlermuster e anstelle von y in der Fehlermusterdatenbank 2 (pattern data base) abgelegt.

Die Reaktion auf Fehler erfolgt nun in einem zweiten Schritt, wie im Folgenden anhand von Fig. 5 dargestellt. Um Fehlerfälle im Betrieb zu identifizieren, läuft während des Betriebs ständig der Beobachter 5 mit, vgl. Fig. 5. Das Modell des Beobachters entspricht dem zuletzt im ersten Schritt verwendeten Modell, d.h. es wird u.U. alle 15 Minuten neu linearisiert. Der Korrekturterm L(yP-^y) verwendet nun die PMU Meßwerte yP, um den Beobachterzustand ^x in der Nähe des Zustands des realen Netzes zu halten. Schließlich wird das Fehlersignal e = yP - ^y gebildet und mit den Mustern in der Fehlermusterdatenbank verglichen (Mustererkennung 4).

Eine alternative Ausführungsform kommt gänzlich ohne Fehlerdatenbank und Stromnetzsimulator aus. Dabei wird ein Beobachter 5 wie in Fig. 5 mit PMU-Meßwerten als Eingangsgrößen betrieben. Zusätzlich werden weitere Beobachter wie in Fig. 5 mit PMU-Meßwerten als Eingangsgrößen betrieben, allerdings unterscheiden sich diese Beobachter dadurch, daß jeder Beobachter auf einen spezifischen Fehlerfall "geeicht" ist. Beschreibt beispielsweise der Parameter p=p0 das fehlerfreie Modell und die Parameter p=p1, p=p2 und p=p3 drei unterschiedliche Fehlerfälle, so läßt man vier Beobachter parallel laufen, je einen mit dem Parameter p0, p1, p2, p3. Im fehlerfreien Fall konvergiert das Fehlersignal e0 = yP - ^y0 gegen null. Falls der Fehler mit den zugehörigen Parameter p1 aufgetreten ist, konvergiert hingegen e0 nicht gegen null und statt dessen das Fehlersignal e1 = yP - ^y1. Entsprechendes gilt für die anderen beiden Fehlerfälle. Somit lassen sich die Fehlerfälle einfach identifizieren. Die Ableitung von effektiven Gegenmaßnahmen muß bei dieser Ausführungsform allerdings auf andere Weise erledigt werden.

Ein wesentlicher erfinderischer Schritt ist die Erkenntnis, daß die Kombination von Simulator, Beobachter und Mustererkennung die Trennung verschiedener Fehlermuster erleichtert. Hierin liegt auch ein wesentlicher Vorteil der Erfindung. Im bisherigen Verfahren sind in den Fehlermustern das nominelle (fehlerfreie) Systemverhalten sowie das fehlerhafte Verhalten überlagert. Bei dem neuen Verfahren wird durch den Beobachter das nominelle Systemverhalten von dem fehlerhaften Verhalten getrennt. Dies erleichtert die Mustererkennung.

Erweiterungen des Verfahrens können für Assistenzsysteme für Stromnetzbetreiber eingesetzt werden, die in kritischen Situationen dem Operator geeignete Gegenmaßnahmen vorschlagen oder automatisiert ausführen.

## Patentansprüche

1. Verfahren zur Generierung von Mustern für die Identifikation von Fehlerfällen in Stromnetzen, bei dem für verschiedene Zeitpunkte
- in einem Stromnetz einen Zustand des Stromnetzes charakterisierende Werte für meßbare stromnetzspezifische Größen verwendet werden,
- Werte für die stromnetzspezifischen Größen mittels eines Modells für das Stromnetz bestimmt werden, wobei
-- die Bestimmung mittels Modell auf bekannten netzspezifischen Eingangsgrößen und nicht bekannten netzspezifischen Größen basiert, und
-- die nicht bekannten netzspezifischen Größen nach Maßgabe eines fehlerfreien funktionierenden Stromnetzes festgelegt sind, und
- ein Muster für die Identifikation von Fehlerfällen durch Bildung der Differenz zwischen den den Zustand charakterisierenden Werten und den mittels Modell bestimmten Werten für die verschiedenen Zeitpunkte generiert wird.

2. Verfahren nach Anspruch 1,
**dadurch gekennzeichnet, daß**
die bekannten netzspezifischen Eingangsgrößen die meßbaren stromnetzspezifischen Größen umfassen.

3. Verfahren nach einem der Ansprüche 1 oder 2,
**dadurch gekennzeichnet, daß**
das Modell auf Basis bekannter netzspezifischer Größen geregelt wird.

4. Verfahren nach einem der vorhergehenden Ansprüche, **dadurch gekennzeichnet, daß**
- mittels eines Systems (1) zur Simulation von Zuständen des Stromnetzes für verschiedene, Fehlerfällen entsprechende Zustände die den jeweiligen Zustand des Stromnetzes charakterisierende Werte für die meßbaren stromnetzspezifische Größen bestimmt werden, und
- mittels diesen Werten die Muster für die Identifikation von den jeweiligen Fehlerfällen generiert werden.

5. Verfahren nach Anspruch 4,
**dadurch gekennzeichnet, daß**
- eine Zuordnung von Mustern für die Identifikation von Fehlerfällen zu Fehlerfällen in einer Datenbank (2) abgespeichert wird.

6. Verfahren nach Anspruch 5,
**dadurch gekennzeichnet, daß**
- eine Zuordnung von Mustern für die Identifikation von Fehlerfällen zu Maßnahmen gegen die zugehörigen Fehlerfälle erfolgt und in einer Datenbank (2) abgespeichert wird.

7. Verfahren nach einem der vorhergehenden Ansprüche, **dadurch gekennzeichnet, daß**
- die einen Zustand des Stromnetzes charakterisierenden Werte für meßbare stromnetzspezifische Größen durch die entsprechenden Meßwerte gegeben sind,
- für eine Mehrzahl von verschiedenen Modellen Werte für die stromnetzspezifischen Größen mittels des Modells bestimmt werden, wobei
-- die Bestimmung mittels Modell auf bekannten netzspezifischen Eingangsgrößen und nicht bekannten netzspezifischen Größen basiert, und
-- die Werte der nicht bekannten netzspezifischen Größen nach Maßgabe eines Fehlerfalls im Stromnetzes festgelegt sind, und
- ein Muster für die Identifikation von Fehlerfällen durch Bildung der Differenz zwischen den den Zustand charakterisierenden Werten und den mittels Modell bestimmten Werten für die verschiedenen Zeitpunkte generiert wird.

8. Verfahren nach Anspruch 7,
**dadurch gekennzeichnet, daß**
- aus den für die Mehrzahl der Modelle generierten Mustern ein Muster nach Maßgabe des auf die Mehrzahl bezogenen Minimums eines Maßes für die absolute Größe von Werten des Musters identifiziert wird, und
- von dem identifizierten Muster auf den zugehörigen Fehlerfall geschlossen wird.

9. Verfahren zur Identifikation von Fehlerfällen in Stromnetzen, bei dem für verschiedene Zeitpunkte
- in einem Stromnetz Meßwerte für stromnetzspezifische Größen verwendet werden,
- Werte für die stromnetzspezifischen Größen mittels eines Modells für das Stromnetz bestimmt werden, wobei
-- die Bestimmung mittels Modell auf bekannten netzspezifischen Eingangsgrößen und nicht bekannten netzspezifischen Größen basiert, und
-- die nicht bekannten netzspezifischen Größen nach Maßgabe eines fehlerfreien funktionierenden Stromnetzes festgelegt sind,
- ein Muster für die Identifikation von Fehlerfällen durch Bildung der Differenz zwischen den Meßwerten und den mittels Modell bestimmten Werten für die verschiedenen Zeitpunkte generiert wird, und
- das Muster mit in einer Datenbank (2) gespeicherten, nach einem Verfahren nach einem der Ansprüche 1 bis 6 erzeugten und Fehlerfällen zugeordneten Mustern verglichen wird.

10. Datenbank (2) mit nach einem Verfahren nach einem der Ansprüche 1 bis 6 erzeugten und Fehlerfällen zugeordneten Mustern.

11. System zur Generierung von Mustern für die Identifikation von Fehlerfällen in Stromnetzen gemäß einem Verfahren nach einem der Ansprüche 1 bis 6, mit einem Modell für das Stromnetz, wobei
- das System für eine Bestimmung mittels Modell auf Basis von bekannten netzspezifischen Eingangsgrößen und nicht bekannten netzspezifischen Größen ausgelegt ist, und
- die nicht bekannten netzspezifischen Größen nach Maßgabe eines fehlerfreien funktionierenden Stromnetzes festgelegt sind.

12. System (1) zur Identifikation von Fehlerfällen in Stromnetzen gemäß einem Verfahren nach Anspruch 8, mit einem Modell für das Stromnetz, wobei
- das System (1) für eine Bestimmung mittels Modell auf Basis von bekannten netzspezifischen Eingangsgrößen und nicht bekannten netzspezifischen Größen ausgelegt ist,
- die nicht bekannten netzspezifischen Größen nach Maßgabe eines fehlerfreien funktionierenden Stromnetzes festgelegt sind, und
- das System eine Datenbank (2) nach Anspruch 10 umfaßt.

13. Computerprogrammprodukt, das in einem computerlesbaren Medium gespeichert ist und computerlesbare Programmmittel umfaßt, mittels derer ein Computer als Datenverarbeitungsanordnung und/oder eine Cloud-basierte Datenverarbeitungsanordnung veranlaßt werden, ein Verfahren nach einem der Ansprüche 1 bis 8 durchzuführen, wenn das Computerprogrammprodukt auf dem Computer und/oder der Cloud-basierten Datenverarbeitungsanordnung läuft.

## Claims

1. Method for the generation of patterns for identifying faults in power supply systems, in which, for various times,
- values characterizing a state of a power supply system are used in the power supply system as measurable variables specific to the power supply system,
- values for the variables specific to the power supply system are determined by means of a model for the power supply system, wherein
-- the determination by means of a model is based on known system-specific input variables and unknown system-specific variables, and
-- the unknown system-specific variables are determined in accordance with a fault-free functioning power supply system, and
- a pattern for identifying faults is generated by forming the difference between the values characterizing the state and the values determined by means of a model for the various times.

2. Method according to Claim 1,
**characterized in that**
the known system-specific input variables comprise the measurable variables specific to the power supply system.

3. Method according to one of Claims 1 or 2,
**characterized in that**
the model is controlled on the basis of known system-specific variables.

4. Method according to one of the preceding claims, **characterized in that**,
- by means of a system (1) for the simulation of states of the power supply system for various states corresponding to faults, the values characterizing the respective state of the power supply system are determined for the measurable variables specific to the power supply system, and
- the patterns for identifying the respective faults are generated by means of these values.

5. Method according to Claim 4,
**characterized in that**
- an assignment of patterns for identifying faults to faults is stored in a database (2).

6. Method according to Claim 5,
**characterized in that**
- an assignment of patterns for identifying faults to measures countering the associated faults is made, and is stored in a database (2).

7. Method according to one of the preceding claims, **characterized in that**
- the values characterizing a state of the power supply system for measurable variables specific to the power supply system are given by the corresponding measured values,
- values for the variables specific to the power supply system are determined by means of the model, for a plurality of different models, wherein
-- the determination by means of a model is based on known system-specific input variables and unknown system-specific variables, and
-- the values of the unknown system-specific variables are determined in accordance with a fault in the power supply system, and
- a pattern for identifying faults is generated by forming the difference between the values characterizing the state and the values determined by means of a model for the various times.

8. Method according to Claim 7,
**characterized in that**,
- from the patterns generated for the plurality of models, a pattern is identified in accordance with the minimum with respect to the plurality of a measure for the absolute magnitude of values of the pattern, and
- the associated fault is deduced from the identified pattern.

9. Method for identifying faults in power supply systems, in which, for various times,
- in a power supply system measured values for variables specific to the power supply system are used,
- values for the variables specific to the power supply system are determined by means of a model for the power supply system, wherein
-- the determination by means of a model is based on known system-specific input variables and unknown system-specific variables, and
-- the unknown system-specific variables are determined in accordance with a fault-free functioning power supply system,
- a pattern for identifying faults is generated by forming the difference between the measured values and the values determined by means of a model for the various times, and
- the pattern is compared with patterns stored in a database (2), generated in accordance with a method according to one of Claims 1 to 6, and assigned to faults.

10. Database (2) with patterns generated in accordance with a method according to one of Claims 1 to 6, and assigned to faults.

11. System for the generation of patterns for identifying faults in power supply systems in accordance with a method according to one of Claims 1 to 6, with a model for the power supply system, wherein
- the system is designed for determination by means of a model on the basis of known system-specific input variables and unknown system-specific variables, and
- the unknown system-specific variables are determined in accordance with a fault-free functioning power supply system.

12. System (1) for identifying faults in power supply systems in accordance with a method according to Claim 8, with a model for the power supply system, wherein
- the system (1) is designed for determination by means of a model on the basis of known system-specific input variables and unknown system-specific variables,
- the unknown system-specific variables are determined in accordance with a fault-free functioning power supply system, and
- the system comprises a database (2) according to Claim 10.

13. Computer program product, which is stored in a computer-readable medium and comprises computer-readable program media, by means of which a computer as a data processing arrangement, and/or a cloud-based data processing arrangement, is caused to execute a method according to one of Claims 1 to 8, when the computer program product is running on the computer and/or the cloud-based data processing arrangement.

## Revendications

1. Procédé de génération d'échantillons pour l'identification de cas de pannes dans des réseaux électriques, dans lequel pour différents moments
- des valeurs caractérisant dans un réseau électrique, le statut du réseau électrique sont utilisées pour des variables mesurables spécifiques au réseau électrique,
- des valeurs pour les variables spécifiques au réseau électrique sont déterminées au moyen d'un modèle pour le réseau électrique, dans lequel
-- la détermination par modèle se base sur des variables d'entrée spécifiques au réseau et qui sont connues et sur des variables spécifiques au réseau qui ne sont pas connues, et
-- les variables spécifiques au réseau qui ne sont pas connues sont fixées en référence à un réseau électrique fonctionnant sans panne, et
- un échantillon destiné à l'identification de cas de pannes est généré pour les différents moments par formation de la différence entre les valeurs caractérisant le statut et les valeurs déterminées par modèle.

2. Procédé selon la revendication 1,
**caractérisé en ce que**
les variables d'entrée spécifiques au réseau et connues comprennent les variables spécifiques au réseau électrique qui sont mesurables.

3. Procédé selon l'une des revendications 1 ou 2,
**caractérisé en ce que**
le modèle est régi sur base de variables spécifiques au réseau qui sont connues.

4. Procédé selon l'une des revendications précédentes, **caractérisé en ce que**
- au moyen d'un système (1) de simulation de statuts du réseau électrique pour différents statuts correspondant à des cas de panne, les valeurs caractérisant le statut respectif du réseau électrique sont déterminées pour les variables spécifiques au réseau et qui sont mesurables, et
- au moyen de ces valeurs, les échantillons pour l'identification des cas de panne respectifs sont générés.

5. Procédé selon la revendication 4,
**caractérisé en ce que**
- une subordination d'échantillons pour l'identification de cas de panne à des cas de panne est conservée en mémoire dans une banque de données (2).

6. Procédé selon la revendication 5,
**caractérisé en ce que**
- une subordination d'échantillons pour l'identification de cas de panne à des mesures contre les cas de panne associés est réalisée et est conservée en mémoire dans une banque de données (2).

7. Procédé selon l'une des revendications précédentes, **caractérisé en ce que**
- les valeurs caractérisant un statut du réseau électrique pour des variables spécifiques au réseau électrique qui sont mesurables sont données par les valeurs de mesure correspondantes,
- pour une pluralité de modèles différents, des valeurs pour les variables spécifiques au réseau électrique sont déterminées au moyen de ce modèle, dans lequel
-- la détermination par modèle se base sur des variables d'entrée spécifiques au réseau et connues et sur des variables spécifiques au réseau et inconnues, et
-- les valeurs des variables spécifiques au réseau qui ne sont pas connues sont fixées en référence à un cas de panne dans le réseau électrique, et
- un échantillon pour l'identification de cas de pannes est généré pour les différents moments par formation de la différence entre les valeurs caractérisant le statut et les valeurs déterminées par modèle.

8. Procédé selon la revendication 7,
**caractérisé en ce que**
- parmi les échantillons générés pour la pluralité des modèles, un échantillon est identifié en référence au minimum, sur base de la pluralité, d'une mesure pour la variable absolue de valeurs de l'échantillon, et
- il est conclu, de l'échantillon identifié, un cas de panne associé.

9. Procédé d'identification de cas de panne dans des réseaux électriques, dans lequel, pour différents moments
- dans un réseau électrique, des valeurs de mesure sont utilisées pour des variables spécifiques au réseau,
- des valeurs pour les variables spécifiques au réseau électrique sont déterminées par un modèle pour le réseau électrique, dans lequel
-- la détermination par modèle se base sur des variables d'entrée spécifiques au réseau et connues et sur des variables spécifiques au réseau inconnues, et
-- les variables spécifiques au réseau et inconnues sont fixées en référence à un réseau électrique fonctionnant sans panne,
- un échantillon pour l'identification de cas de pannes est généré pour les différents moments par formation de la différence entre les valeurs de mesure et les valeurs déterminées par modèle, et
- l'échantillon est comparé avec des échantillons stockés dans une banque de données, produits conformément à un procédé selon l'une des revendications 1 à 6 et subordonnés à des cas de panne.

10. Banque de données (2) comprenant des échantillons produits d'après un procédé selon l'une des revendications 1 à 6 et subordonnés à des cas de panne.

11. Système de génération d'échantillons pour l'identification de cas de panne dans des réseaux électriques d'après un procédé selon l'une des revendications 1 à 6, comprenant un modèle pour le réseau électrique, dans lequel
- le système est configuré pour la détermination par modèle sur base de variables d'entrée spécifiques au réseau et connues et de variables spécifiques au réseau et inconnues, et
- les variables spécifiques au réseau qui ne sont pas connues sont fixées en référence à un réseau électrique fonctionnant sans panne.

12. Système (1) pour l'identification de cas de panne dans des réseaux électriques conformément à un procédé selon la revendication 8, comprenant un modèle pour le réseau électrique, dans lequel
- le système (1) est configuré pour la détermination par modèle sur base de variables d'entrée spécifiques au réseau et connues et de variables spécifiques au réseau et inconnues,
- les variables spécifiques au réseau et inconnues sont fixées en référence à un réseau électrique fonctionnant sans panne, et
- le système comprend une banque de données (2) selon la revendication 10.

13. Produit de programme informatique, lequel est stocké dans un support pouvant être lu par un ordinateur et qui comprend des programmes pouvant être lus par un ordinateur, au moyen desquels un ordinateur est préparé en tant que montage de traitement de données et/ou montage de traitement de données sur Cloud, pour exécuter un procédé selon l'une des revendications 1 à 8, quand le produit de programme informatique tourne sur l'ordinateur et/ou le montage de traitement de données sur Cloud.
